# EUROPEAN PATENT APPLICATION

(11) **EP 4 075 495 A1**
(43) Date of publication of application: **19.10.2022**
(21) Application number: 21168339.6
(22) Date of filing: 14.04.2021
(51) Int. Cl.: H01L 23/373, C04B 37/00

(54) **SUBSTRATE FOR A POWER MODULE, POWER MODULE AND METHOD FOR MANUFACTURING A POWER MODULE**

(71) Applicant: Hitachi Energy Switzerland AG, 5400 Baden (CH)
(72) Inventor: MALEKI, Milad, 5417 Untersiggenthal (CH); BEYER, Harald, 5600 Lenzburg (CH); FISCHER, Fabian, 5400 Baden (CH); LUDWIG, Maxime, 8003 Zürich (CH); GUILLON, David, 8857 Vorderthal (CH)
(74) Representative: Epping - Hermann - Fischer

(57) **Abstract**

The present disclosure relates to a substrate (200) for a power module (210) comprising a carrier sheet (201) with an insulating layer. The substrate (200) further comprises a first metallization layer (202) formed on a first surface of the carrier sheet (201), the first metallization layer (202) comprising a mounting area (207) for mounting at least one semiconductor die (204) of a power module (210), and a second metallization layer (205) formed on a second surface of the carrier sheet (201) and comprising an attachment area (206) for attaching the substrate (200) to a flat surface. At least a part of the mounting area of the first metallization layer (202) is structured using a plurality of first grooves (203) extending from an outer surface of the first metallization layer (202) to the insulating layer to electrically separate individual parts (202a, 202b, 202c) of the first metallization layer (202). At least a part of the attachment area of the second metallization layer (205) is structured using at least one second groove (211) extending from an outer surface of the second metallization layer (205) at least partially to the at least one insulating layer.

The disclosure further relates to a power module (210) comprising such a substrate (200) and a method for manufacturing a corresponding power module (210).

## Description

The present disclosure relates to a substrate for a power module comprising a carrier sheet, a first metallization layer and a second metallization layer. The present disclosure further relates to a power module comprising such a substrate, and a manufacturing method for manufacturing such a power module.

Document JP 2002-344094 A relates to a circuit board for a power module, and more particularly to a circuit board for a power module having an improved thermal cycling behavior by forming a groove next to an edge of a metallization pattern, for example for an inverter device for an automobile.

It is an object of the present disclosure to provide a substrate and module suitable for the implementation of power electronics and corresponding manufacturing methods, which are relatively easy to manufacture, can withstand thermal and/or mechanical stress during manufacturing and their operation, and operate reliably, even in the presence of high currents and/or voltages.

According to an aspect of the disclosure, a substrate for a power module is provided. The substrate comprises a carrier sheet extending in a plane and comprising at least one insulating layer, a first metallization layer formed on a first surface of the carrier sheet, the first metallization layer comprising a mounting area for mounting at least one semiconductor die of a power module, and a second metallization layer formed on second surface of the carrier sheet, the second surface being opposite to the first surface, the second metallization layer comprising an attachment area for attaching the substrate to a flat surface. The projections of the mounting area and the attachment area into the plane of the carrier sheet at least partially overlap. The mounting area is structured using at least one first groove extending from an outer surface of the first metallization layer to the at least one insulating layer to electrically separate individual parts of the first metallization layer. The attachment area is structured using at least one second groove extending from an outer surface of the second metallization layer at least partially to the at least one insulating layer.

By structuring at least parts of the opposite mounting and attachment areas, a bending or warping of a carrier sheet during thermal or mechanical stress cycles, for example during manufacturing, can be reduced, resulting in a reduced bow of the finished substrate. Reducing the bow of the substrate will in turn reduce stress in any mechanical connection between the substrate and any carrier structure, resulting in a higher reliability of an assembly, such as a power module.

According to a further embodiment, a conductive material is arranged at the bottom of the at least one second groove, which interconnects edges of respective parts of the second metallization layer adjoining the at least one second groove, for example by arranging an electrically conductive layer at a bottom part of the trench or by filling at least the bottom part of the trench with an elastic electrically conductive material.

By forming an electrical connection between the sides of the second groove, locally high electric field in the carrier sheet and the second groove, occurring mostly on edges and corners of the metallization layer, can be avoided, reducing electrical stress and avoiding a partial discharge and dielectric breakdown during operation.

According to a further embodiment, the carrier sheet further comprises at least one first conductive layer arranged between the at least one insulating layer and the second metallization layer. The at least one second groove extends from the outer surface of the second metallization layer to a surface of the at least one first conductive layer. The at least one first conductive layer interconnects the edges of the respective parts of the second metallization layer adjoining the at least one second groove. By keeping the first conductive layer intact, an electrical interconnection can be established that will mitigate any negative electrical effects associated with the second groove.

For example, the substrate may be an active metal brazing (AMB) substrate, and the at least one conductive layer may be a brazing layer formed on the surface of the at least one insulating layer. Such a structure is easy to manufacture. Separating the second metallization layer by means of the second groove will balance the structuring of the first metallization layer. At the same time, an additional conductive layer, such as a brazing layer, may be used as a processing-stop, for example as an etch-stop during etching, and also to electrically connect adjoining edges of the respective parts of the second metallization layer.

According to a further embodiment, the at least one second groove is formed as a trench extending from the outer surface of the second metallization layer to the at least one insulating layer. An electrically conductive layer is arranged at a bottom part of the trench such that the edges of the respective parts of the second metallization layer adjoining the at least one second groove are interconnected. By covering an exposed part of the at least insulating layer, for example with a thin conductive layer, or filling at least a bottom part of the at least one trench, for example with an elastic conductive material, an electrical interconnection can be established that will mitigate any negative electrical effects associated with the second groove.

For example, the substrate may be one of a directly bonded copper (DBC) substrate or a directly bonded aluminum (DBA) substrate. Alternatively or in addition, the second metallization layer may be directly bonded to a surface of the at least one insulating layer of the carrier sheet. Such substrates are widely available and have various advantageous effects, including advantageous thermal properties for power electronics.

According to a further aspect, a power module is provided, comprising a substrate according to one of the embodiments, and at least one semiconductor die mounted in the mounting area of the first metallization layer.

Attaching at least one semiconductor die to a mounting area of a substrate, for example by soldering, sintering or similar processing steps, often requires heat treatment of the substrate or the at least one semiconductor die. Due to the presence of the at least one second groove in the second metallization layer, a bow in the substrate will be avoided or at least mitigated, thereby avoiding or mitigating an improper joining connection of the power module when mounting at least one semiconductor die on the substrate and/or when mounting the substrate to an underlying carrier structure, such as a baseplate, a cooler or the like, where heat may be applied to the substrate.

According to a further embodiment, the power module further comprises a carrier structure, wherein the attachment area is attached to a flat surface of the carrier structure. The carrier structure comprising at least one of an electrically conductive carrier plate in electrical and/or thermal contact with the second metallization layer, a base plate in thermal contact with the second metallization layer, or a cooler in thermal contact with the second metallization layer. By reducing the bow of the substrate of the power module, the substrate can be attached on a larger flat surface area of a carrier structure, comprising one or more of a base plate, an electrical carrier plate and a cooler.

According to a further aspect, a method for manufacturing a power module is provided. The method comprises providing a substrate comprising at least an insulating layer, a first metallization layer and a second metallization layer, the first and second metallization layers being arranged on opposite sides of the insulating layer; structuring the first metallization layer to form at least one first groove electrically separating the first metallization layer into a plurality of individual parts; structuring the second metallization layer to form at least one second groove in an attachment area of the second metallization layer, wherein the at least one second groove extends at least partially from an outer surface of the second metallization layer towards the insulating layer; mounting at least one semiconductor die in a mounting area of the first metallization layer; and attaching at least the attachment area of the second metallization layer to a flat surface.

The above steps result in the manufacturing of a power module having a reduced bow as detailed above with respect to the other aspects of the disclosure.

According to a further embodiment, in a step of structuring the second metallization layer, the second metallization layer is etched, and an etching method, an etching time, an etching agent and/or etchant concentration is selected such that the at least one second groove does not extend all the way to the insulating layer. By using appropriate etching parameters, a partial etching of the second metallization layer can be achieved, which helps to mitigate unwanted electrical effects during operation of the power module.

The method for manufacturing described above is suitable, for example, for the manufacturing of a substrate of a power module and a corresponding power module as described above. Features and advantages described in connection with the substrate and the power module can therefore be used for the method for manufacturing and vice versa.

The present disclosure comprises several aspects of an invention. Every feature described with respect to one of the aspects is also disclosed herein with respect to the other aspect, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows schematically a view of a front side metallization layer of a conventional substrate carrying semiconductor dies.
Figure 2 shows schematically a view of a back side metallization layer of the substrate of Figure 1.
Figure 3 shows schematically a cross-section through the substrate of Figures 1 and 2.
Figure 4 shows schematically a contact area between the substrate of Figures 1 to 3 and a flat surface.
Figure 5 shows schematically a view of a front side metallization layer according to an embodiment of the disclosure.
Figure 6 shows schematically a view of a back side metallization layer of the substrate of Figure 5.
Figure 7 shows schematically a cross-section through the substrate of Figures 5 and 6.
Figure 8 shows schematically a contact area between the substrate of Figures 5 to 7 and a flat surface.
Figure 9 shows a simulation of an electrical field strength in the area of a groove in a second metallization layer below an uninterrupted first metallization layer.
Figure 10 shows a simulation of an electrical field strength in the area of a groove in a second metallization layer below an interrupted first metallization layer.
Figure 11 shows schematically a cross-section through a substrate according to another embodiment.
Figure 12 shows a cross-section through a substrate according to another embodiment.
Figure 13 shows a simulation of an electrical field strength in the area of a groove in a second metallization layer below an uninterrupted first metallization layer.
Figure 14 shows a simulation of an electrical field strength in the area of a groove in a second metallization layer below an interrupted first metallization layer.
Figure 15 shows schematically a cross-section through a substrate according to another embodiment.
Figure 16 shows schematically a cross-section through a substrate according to another embodiment.
Figure 17 shows schematically a method for manufacturing a power module.

While the invention is amenable to various modifications and alternative forms, specifics thereof have been shown by way of example in the figures and will be described in detail. It should be understood, however, that the intention is not to limit the invention to the particular embodiments described. On the contrary, the intention is to cover all modifications, equivalents, and alternatives falling within the scope of the invention defined by the appended claims.

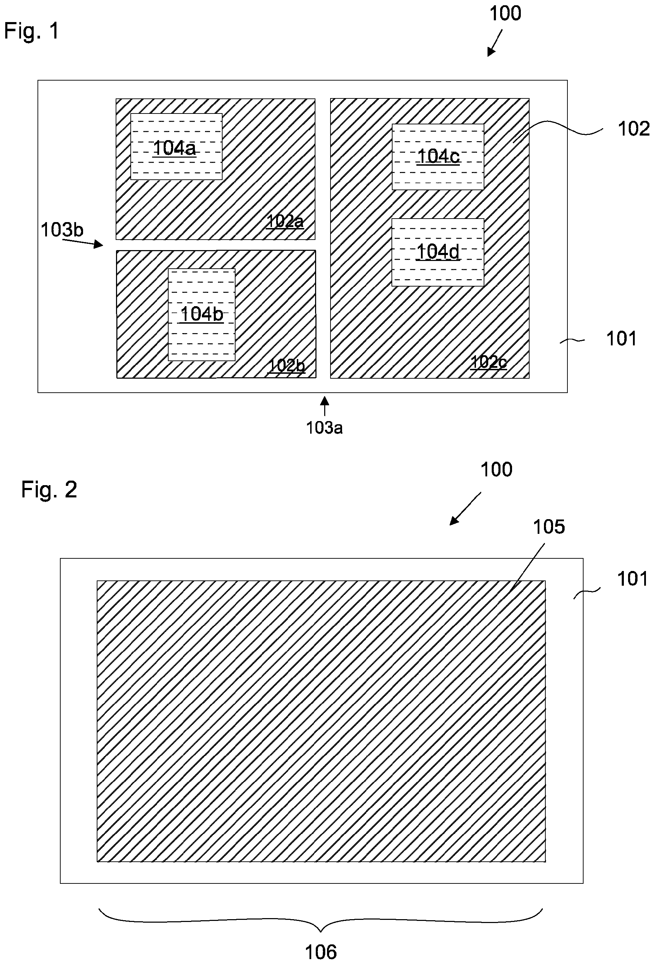

Before describing various embodiments of the disclosure in more detail, at first, problems that may arise in the manufacturing of power modules using conventional techniques are illustrated using Figures 1 to 4.

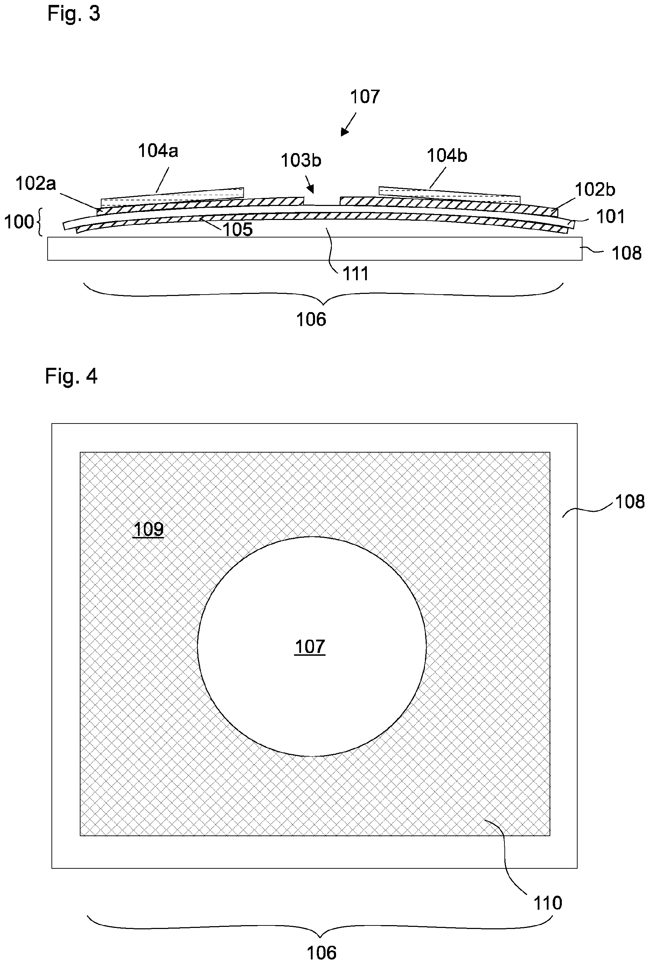

Figure 1 shows a conventional, insulating carrier sheet 101 of a substrate 100 having a first metallization layer 102 formed on its first or front surface. In the depicted example, the material of the first metallization layer 102 is separated by two grooves 103a and 103b into three individual parts 102a, 102b and 102c. The grooves 103a and 103b extend from an outer surface of the first metallization layer 102 through the entire thickness of the first metallization layer 102 to the carrier sheet 101. In the example shown in Figure 3, the groove 103b extend from an upper surface of the individual parts 102a and 102b all the way to a contact interface between the individual parts 102a, 102b and 102c of the first metallization layer 102 and the insulating carrier sheet 101 underneath. The upper surface and the contact interface are located on opposite main faces of the first metallization layer 102.

On the parts 102a to 102c, a total of four semiconductor dies 104a, 104b, 104c and 104d are mounted. In the embodiment shown in Figure 1, each of the semiconductor dies 104a to 104d is mounted on one of the parts 102a to 102c of the first metallization layer 102. Further contacts may be provided from the top surface of the semiconductor dies 104a to 104d. In alternative embodiments not shown in the figures, one or more of the semiconductor dies 104a to 104d or other discrete devices, such as NTC resistors, having two or more terminals may extend across several of the parts of the first metallization layer 102. Of course, the number of the parts of the first metallization layer 102, the number of isolating grooves 103 there between and the number of components attached thereto is not-limited in any way and will vary depending on the intended module design and purpose.

Figure 2 shows an opposite second or back surface of the carrier sheet 101 of the substrate 100 of Figure 1. As can be seen, a large proportion of the back surface is covered with one homogenous second metallization layer 105. The second metallization layer 105 essentially forms an attachment area 106 is typically used to mount the carrier substrate 100 to a flat surface, such as carrier plate made from an electrically conductive material, such as a metal or composite material like AlSiC or MgSiC, and provides a common electrical potential, typically electrical ground, or a contact area of a base plate or cooler acting as heat sink.

During manufacturing, the substrate 100 as shown in Figures 1 and 2 will undergo various processing steps. Several of these processing steps will be performed at elevated temperatures and/or mechanical forces. For example, the semiconductor dies 104a to 104d may be soldered or sintered to the first metallization layer 102 using heat treatment. In the case of sintering, in addition pressure will be applied to the substrate 100. Due to the physical imbalance between the first metallization layer 102 and the second metallization layer 105, the substrate 100 comprising the carrier sheet 101, the first metallization layer 102 and the second metallization layer 105 may bent in response to thermal and/or mechanical stress, resulting in a bow as shown in Figure 3. This effect is relevant, for example, for the design of power electronics modules, which use relatively large substrates with relatively large metallization features to cope with the respective current, thermal and reliability requirements. In the exemplary embodiment, a central region 107 of the substrate 100 bends upwards, i.e. away from a flat surface of an underlying base plate 108, and forms a gap 111 there between. This is undesirable for several reasons.

For example, as shown in Figure 4, if the second metallization layer 105 will be attached to the underlying base plate 108 by soldering, solder 109 will only connect the second metallization layer 105 and the base plate 8 in a peripheral region 110 of the attachment area 106. In contrast, the gap 111 formed in the central region 107 of the attachment area 106 results in a weaker thermal, mechanical and/or electrical connection between the base plate 108 and the substrate 100. Even if no gap 111 is formed, a resulting solder layer will have an inhomogeneous thickness, which may result in lower reliability with respect to thermomechanical stress. Accordingly, such a bow is problematic with respect to properly and homogeneously joining the substrate 100 to the underlying base plate 108. It may also cause thermal issues by enhanced thermal resistance. Moreover, bending of the substrate 100 makes it generally more difficult to handle and process the substrate 100 in subsequent processing steps. Later on, the stress generated by such a bow of the substrate 100 may also result in reduced lifetime of a finished device, such as a power module, with respect to thermal cycles.

Among others, the inventors have found that the above negative effects can be mitigated by providing at least one groove in the attachment area 106 of the second metallization layer 105. By doing so, this structuring of the first and second metallization layers 102 and 105 can at least be partially balanced to compensate for stress, resulting in a reduced bow of the substrate 100.

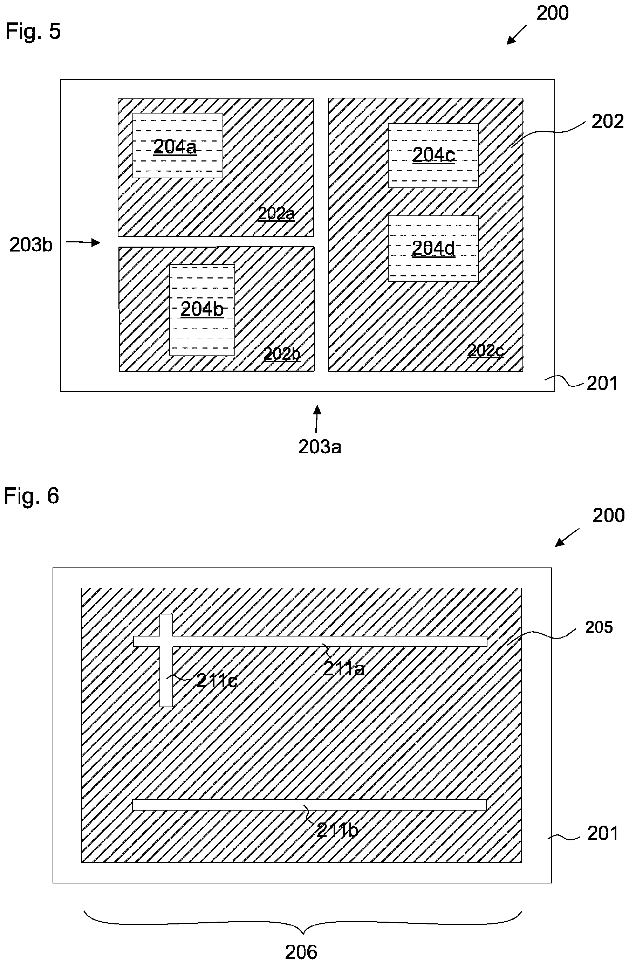

An improved embodiment of a substrate 200 is described with respect to Figures 5 to 8. The front side metallization layer 202 and arrangement of semiconductor dies 204a to 204d shown in Figure 5 correspond to the front side of the substrate 100 shown in Figure 1. For brevity, reference is made to the corresponding parts above. However, to at least partially balance the two grooves 203a and 203b provided in the first metallization layer 202, the second metallization layer 205 shown in Figure 6 also comprises a number of second grooves, which help to reduce mechanical stress and therefor results in a reduced bow of the substrate 200.

As detailed above with respect to the first grooves 103, the second groves extend from an outer surface of the second metallization layer 205 inwards, i.e. towards the carrier sheet 201. The term "outer surface" refers to the surface of the second metallization layer 205 opposite from an interface between the second metallization layer 205 and the carrier sheet 201, i.e. the surface facing towards a flat surface for mounting the substrate 200. In the described example, the outer surface of the second metallization layer 205 is attached to a flat surface of a base plate 208.

In the depicted example, two horizontal grooves 211a and 211b and a vertical groove 211c are provided. The thickness of the metallization layers 202 and 205 may lies between 0.1 and 5 mm, for example between 0.1 and 3 mm or between 0.1 and 1 mm. In the described example, the first metallization layers 202 has a thickness of 0.5 mm and the second metallization layers 205 has a slightly lower thickness of 0.4 mm. Alternatively, the two metallization layers 202 and 205 may have the same thicknesses. In general, a position of grooves on the top side and thickness ratio of metallization layers should be considered for stress compensation.

In a first approximation, the second grooves 211 in a backside metallization provided by the second metallization layer 205 are prepared under corresponding first grooves 203 of a top metallization provided by the first metallization layer 202. Nevertheless, as shown in Figures 5 and 6, this may deviate due to an individual stress situation, for example caused by different metallization thicknesses and/or mounted semiconductor dies 204.

Attention is drawn to the fact that, despite the presence of the second grooves 211a to 211c, all parts of the second metallization layer 205 remain on the same electrical potential, e.g. are electrically connected. In the embodiment show in Figure 6, this is achieved in that all grooves 211a to 211c are surrounded by the material of the second metallization layer 205. This can also be achieved by attaching all parts of the second metallization layer 205 to a common conductive carrier plate, or by keeping or providing conductive material at the bottom of the grooves 211a to 211c as detailed later. In contrast, the various parts 202a to 202c of the first metallization layer 202 are electrically isolated from one another to allow for the desired operation and control of the semiconductor dies 204a to 204d, such as high-power FETs, diodes or IGBT structures.

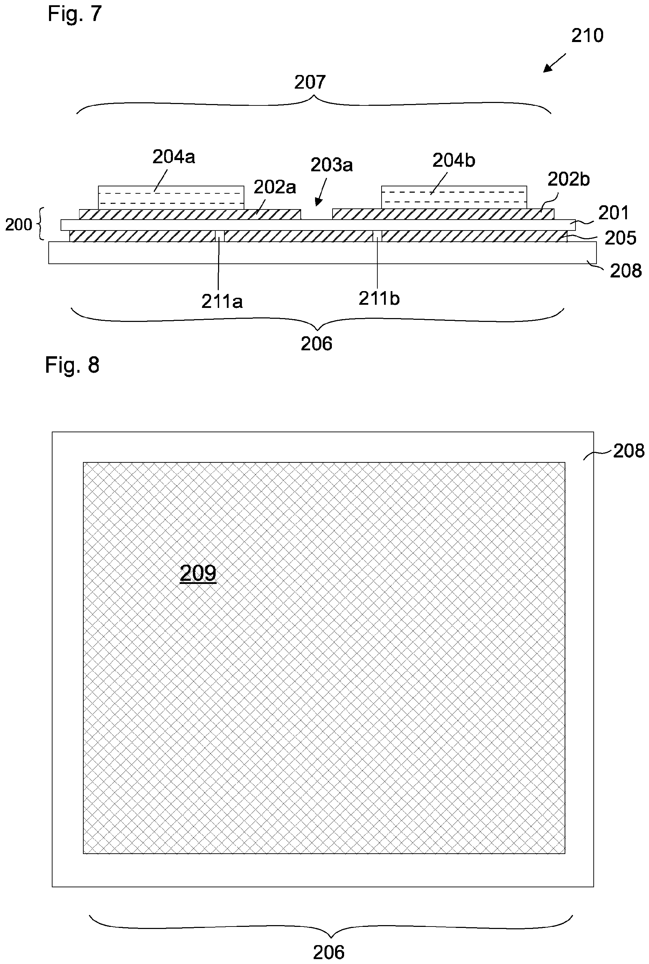

The presence of the second grooves 211a to 211c mostly balances the presence of the first grooves 203a and 203b in the first metallization layer 202. Moreover, in case of different thickness of the metallization layers 202 and 205, the second grooves 211a to 211c may also balance effects caused by this imbalance. As a consequence, even after heat treatment and attaching the semiconductor dies 204a to 204d to the first metallization layer 202, the substrate 200 remains essentially flat, as shown in Figure 7.

As a result, essentially all parts of the second metallization layer 205 forming an attachment area 206 are in direct contact with an underlying flat surface. For example, the substrate 200 may be sintered or soldered to a flat metal surface area of the base plate 208 and/or a cooler (not shown in the Figures) used to cool the semiconductor dies 204a to 204d. This will result in a mechanically more stable connection between the substrate 200, the semiconductor dies 204a to 204d placed on its surface and any carrier structure underneath. Moreover, it results in a lower thermal resistance value R between the active semiconductor components and any attached cooling assembly.

This situation is depicted in the uninterrupted solder 209 shown in Figure 8. As a result, a power module 210 comprising an essentially flat substrate 200, one or more semiconductor dies 204 arranged on a mounting area 207 on one side of the substrate 200 and, optionally, a base plate 208, an electrically conductive carrier plate and/or a cooler arranged in an attachment area 206 on the opposite side of the substrate 200 can be formed. The attachment area 206 and the mounting area 207 of the substrate at least partially overlap, when projected into the central plane of the substrate 200.

The first and second metallization layers 202 and 205 may have the same size, but may also differ in absolute size as shown in Figure 7. In general, the grooves 203a and 203b are separating metal patterns, on which semiconductor dies 204a to 204d are mounted, corresponding to the individual parts 202a to 202c of the first metallization layer 202. Thus, the grooves are typically found in a central part of the substrate 200, and not exclusively on its edges. This is also the case for the second grooves 211a to 211c of the second metallization layer 205. Thus, the terms attachment area 206 and the mounting area 207 refer to an inner, central part of the respective metallization layers 202 and 205, respectively, rather than an outer, peripheral area close to the edge of the carrier sheet 201. For example, they may be defined as covering 95, 90 or 80 percent of the inner surface area of each side of the carrier sheet 201, or, inversely, to exclude the outer 5, 10 or 20 percent, respectively, closest to the edge of the carrier sheet 201, which may be referred to as peripheral area. In one example, the outer, peripheral area may cover a border area having a width of less than 5 mm for example 2mm, as measured from the edge of the substrate 200.

As shown in Figure 7, the second grooves 211a to 211c extend all the way from the lower, outer surface of the second metallization layer 205 forming the attachment area 206 to the carrier sheet 201. In the described example, the carrier sheet 201 is made completely from an insulating material, e.g. a ceramic sheet for high voltage applications or a resin sheet for other applications. As described before, such a complete removal of the metal material of the second metallization layer 205 in the area of the second grooves 211a to 211c can be used to mitigate the bow of the substrate 200.

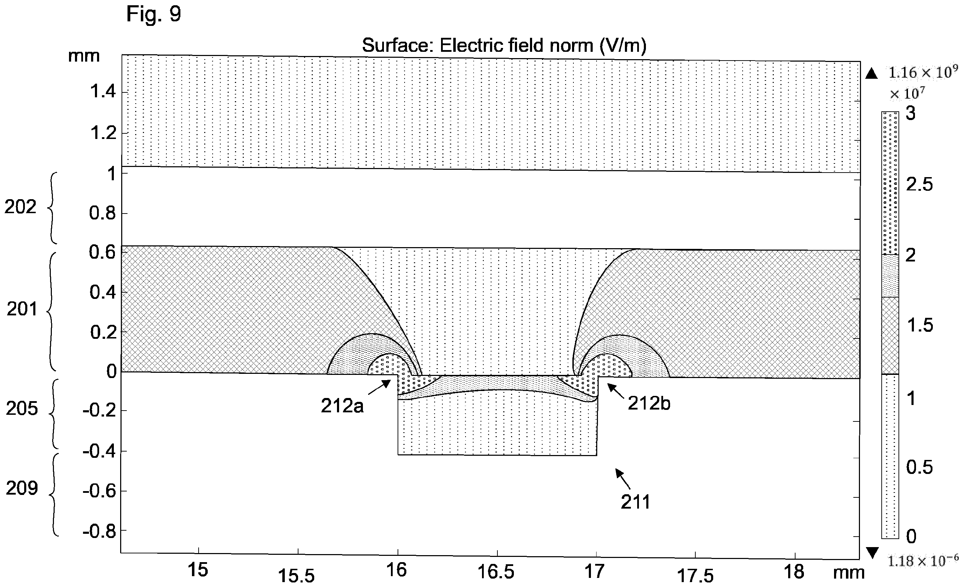

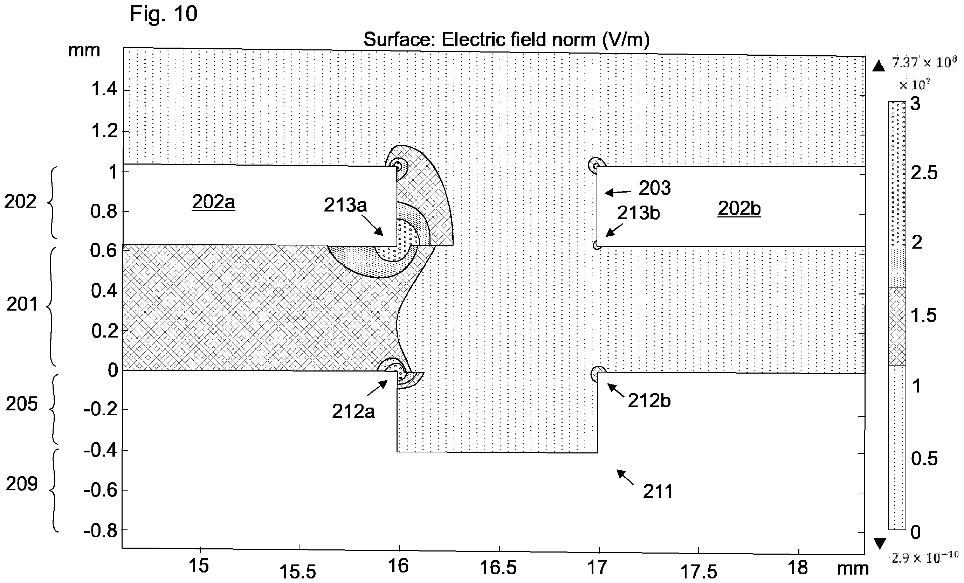

However, as next discussed with regard to Figures 9 and 10, the inventors have also discovered that the complete removal of an electrically conductive material of a second metallization layer 205 in the area of second grooves between an insulating material of a carrier sheet 201 and an underlying carrier structure may also have some negative effects during operation of a power module making use of such a substrate 200. In particular, open lying surface of the insulating carrier sheet 201 may cause the generation of high electric fields and partial discharges on edges of the remaining parts of the second metallization layer 205.

Figure 9 shows a simulation of the electrical field strength in such an arrangement. For simplicity, only a single groove 211 in a second metallization layer 205 is shown. Above an insulating carrier sheet 201, an uninterrupted first metallization layer 202 is shown. For the simulation, the solder 209, any carrier structure below (not shown in Figure 9) as well as the adjoining parts of the lower, second metallization layer 205 are connected to a low electrical potential, e.g. electrical ground. The upper, first metallization layer 202 is connected to a high electrical potential, e.g. a positive voltage. On the right and left-hand side of Figure 9, i.e. away from the second groove 211, the electrical field is mostly homogenous inside the insulating carrier sheet 201 with a constant gradient in the electrical potential. However, coming closer to the groove 211 and especially at the corners 212a and 212b, where the groove 211 touches the insulated carrier sheet 201, relatively large changes in the electrical field can be noticed, potentially resulting in partial discharges next to the edge and inside the groove 211. Such partial discharges can be problematic when operating the resulting power module with high voltages and/or frequencies, resulting in a shorter module lifetime or lower yield during production.

Figure 10 shows a second simulation similar to the one described above with regard to Figure 9. Contrary to the situation in Figure 9, in the situation depicted in Figure 10 the first metallization layer 202 is also separated by a first groove 203, which is collocated, in a horizontal direction, with the second groove 211. Moreover, while the left part 202a of the first metallization layer 202 is again connected to a high electrical potential, the right-hand part 202b of the first metallization layer 202 is connected to a low electrical potential corresponding to the potential of the second metallization layer 205, the solder 209 and any carrier structure below (not shown in Figure 10) underneath, e.g. electrical ground. Accordingly, in the right-hand part of Figure 10, there is practically no electrical field between the two metallization layers 202 and 205. In the very left-hand part of Figure 10, a homogenous electrical field strength can be observed, which corresponds to the electrical field strengths shown in the corresponding part of Figure 9. In this example, a high electrical field strength can be observed in the left corner 212a of the second groove 211, but not in the right corner 212b of the second groove 11. Correspondingly, an area surrounding corresponding corner 213a of the first groove 203 shows a locally very high electrical field strength. The electrical field strength in these areas of the first groove 203 may be reduced by coating of critical positions by a polyimide layer and/or embedding the module interior into a dielectric gel. Moreover, a gel and/or a polyimide may improve the dielectric breakdown strength of the arrangement. However, this approach cannot be easily applied to the second groove 211 in the second metallization layer 205, as it may interfere with a soldering process for soldering the mounting area 207 to a base plate 208 or other carrier structure.

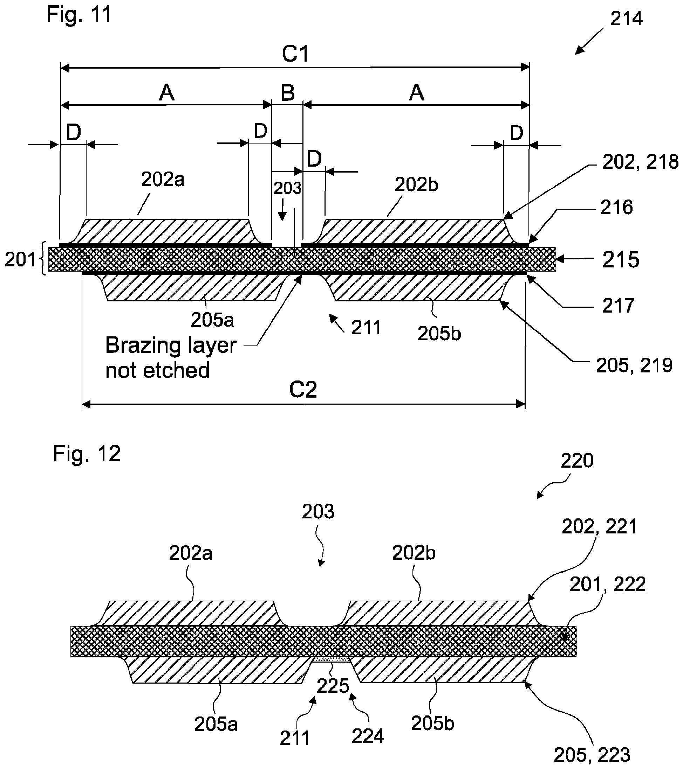

Figure 11 shows a further embodiment of a substrate according to an embodiment of the disclosure. In the embodiment shown in Figure 11, a so-called active metal brazing (AMB) substrate 214 is provided. The AMB substrate 14 comprises a middle ceramic layer 215 serving as insulating layer of the substrate 214, coated on the upper and lower side with a brazing layer 216 and 217, respectively. On outside surface of the brazing layers 216 and 217, an upper, first metallization layer 202 and a lower, second metallization layer 205 is provided, respectively. In the described embodiment, the first metallization layer 202 is provided by an upper copper layer 218, and the lower second metallization layer 205 is provided by a lower copper layer 219. Alternative, aluminum may be used to provide the metallization layers 202 and/or 205. Together, the electrically insulating ceramic layer 215, as well as the electrically conductive upper and lower brazing layers 216 and 217 correspond to the carrier sheet 201 of the substrate 200 as detailed above with respect to Figure 7.

As can be seen in Figure 11, both the upper copper layer 218 as well as the lower copper layer 219 are structured using grooves 203 and 211, respectively, for example by selectively etching the copper layers 218 and 219. A mounting area provided on the top surface of the upper copper layer 218 having a width C1 is separated into two parts 202a and 202b, each having a width of A. These two parts 202a and 202b are separated by an isolation trench in the form of a first groove 203 having a width B. Attention is drawn to the fact that the underlying brazing layer 216 is also absent in the area of the first groove 203, for example etched away. Between the top surface of the respective parts 202a and 202b of the upper copper layer 218 and the underlying ceramic layer 215, transition zones having a width of D are provided in which the upper copper layer 218 is only partially missing and the upper brazing layer 216 remains intact. Instead of etching, other methods for structuring are also possible, and include lamination of metal pieces on a carrier sheet 201 to form a substrate 200, or production of a substrate 200 by additive manufacturing methods, e.g. selective coating with a metal material.

Correspondingly, the lower, second metallization layer 205 of the AMB substrate 214 is also structured to balance the presence of the structuring of the first metallization layer 202, for example by etching. However, unlike in the structuring of the upper surface of the AMB substrate 214, the trenches in the lower copper layer 219 of the AMB substrate 2014 do not extend through the lower brazing layer 217. Instead, when a second groove 211 in the attachment area 206 of width C2 is formed, for example by etching, the lower brazing layer 217, typically comprising other materials than the second metallization layer 205, such as titanium nitride (TiN), silver (Ag) and/or a silver/copper alloy (Ag/Cu), is used as a processing-stop, for example as an etch-stop in an etching process, and remains essentially intact, as shown in Figure 11. Consequently, the left and right adjoining parts 205a and 205b of the second metallization layer 205 remain electrically connected by means of the lower brazing layer 217. This will result in a higher yield during production, a better process stability, and is relatively easy to implement with conventional semiconductor processing equipment. Maintaining the electrical connection prevents high electric field strengths and partial discharge in the second groove 211.

Attention is drawn to the fact that the single groove 211 shown in Figure 11 is only used as an example to explain the formation of an individual groove 211. In practice, a more complicated groove structure may be provided in a second metallization layer 205 of a substrate 200 to be used for a given power module. For example, one or more closed and/or intersecting second grooves 211 of varying thicknesses and length may be provided. The exact number, orientation, connection and width of the second grooves 211 provided in the second metallization layer will generally depend on the structuring of the first metallization layer 202 and, optionally, its occupation with semiconductor dies 204 and any other components (not shown), as well as the relative thicknesses of the first and second metallization layers 202 and 205. A suitable structure for the grooves 211 of the second metallization layer 205 can be obtained by experiments or simulations.

As guiding principle, an amount of material remaining above the carrier sheet 201 should corresponds to an amount of material remaining below the carrier sheet. As an approximation an amount of material of the first metallization layer 202 should correspond to an amount of material of the second metallization layer. Inversely, if the first and second metallization layers are of similar size, the volume of metal removed or omitted from the second metallization layer 205 during structuring should roughly equate to the amount of metal removed from the first metallization layer 202. Thus, for metallization layer 202 and 205 of equal thickness, the surface area of the first grooves 203 and second grooves 211 should be similar. For a thicker first metallization layer 202, more material has to be removed or omitted from the second metallization layer 205 or more second grooves 211 have to be implemented in the second metallization layer 205. Additionally, semiconductor dies 204 or other components mounted on the first metallization layer 202 may also have an influence and can be taken into account to determine the size and position of the one or more second groves 211. Further, it may be beneficial, if the groove structure in the second metallization layer 205 at least partially overlaps with the groove structure in the first metallization layer 202, when projected into the plane of the substrate 200. For example, in case a thickness of the first metallization layer 202 corresponds to a thickness of the second metallization layer, the at least one first groove 203 and the at least one second groove may be congruent. Alternatively, when a thickness of the first metallization layer 202 differs from a thickness of the second metallization layer 205 and/or when semiconductor dies are joined to the first metallization layer 202, at least parts of the at least one first groove 203 and the at least one second groove 211 are non-congruent. For example, the positions of the at least one first groove 203 and the at least one second groove 211 may be co-located, but the at least one first groove 203 may have a larger or smaller width than the at least one second groove 211.

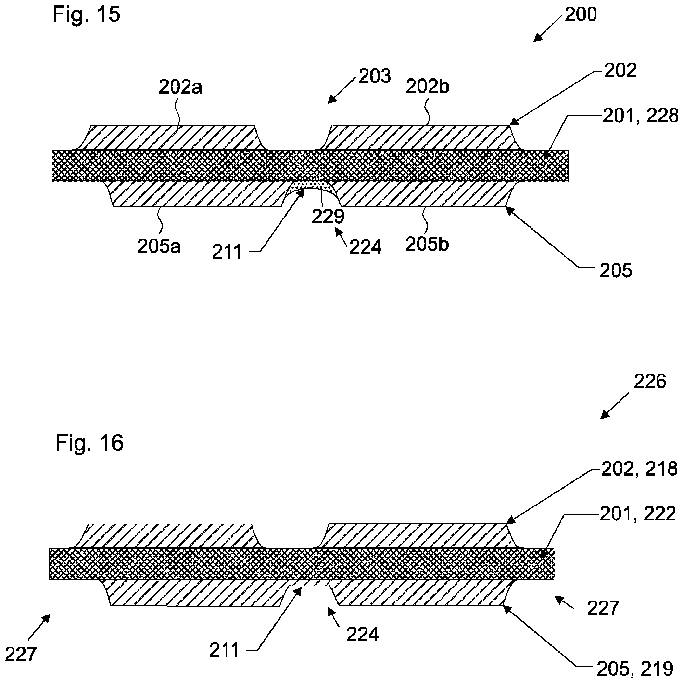

Figure 12 shows a further embodiment according to the present disclosure. Contrary to Figure 11, the embodiment shown in Figure 15 shows a direct bonded aluminum (DBA) substrate 220. Similarly, a direct bonded copper (DBC) may be used. In the described embodiment, an upper aluminum layer 221 is directly bonded to a ceramic substrate 222 serving as insulating layer. Similarly, a lower aluminum layer 223 is directly bonded to a lower surface of the ceramic substrate 222.

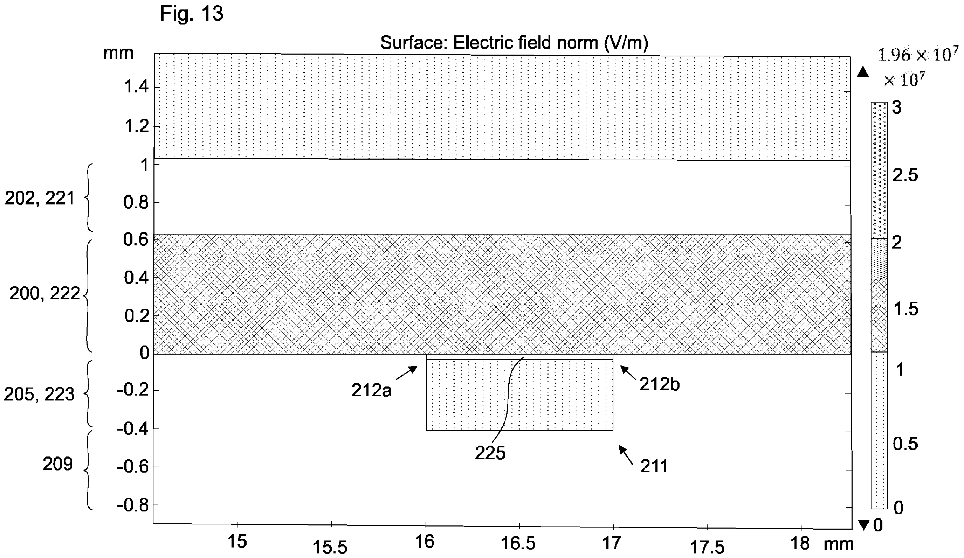

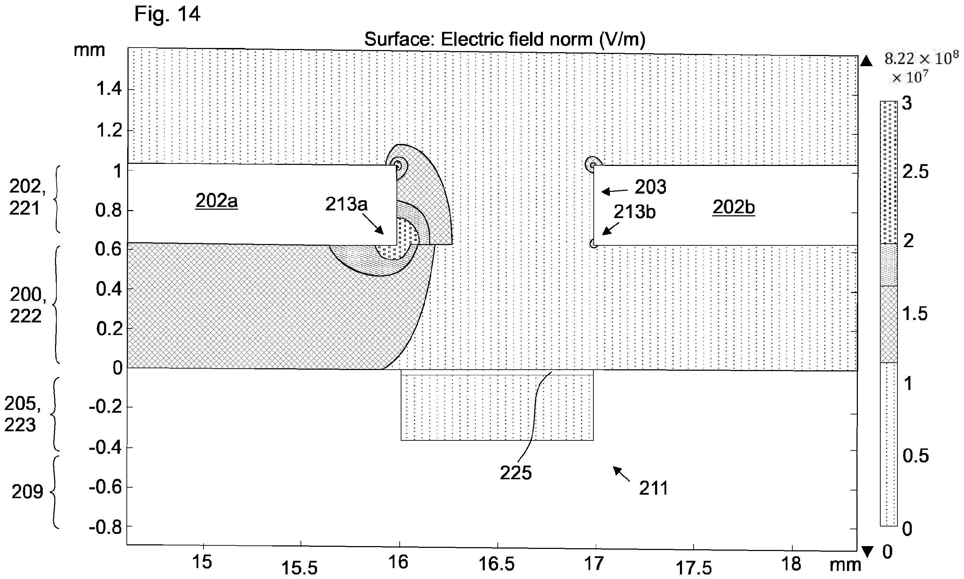

With exception of the metal material and the absence of the brazing layers 216 and 217, the overall structure of the DBA substrate 220 corresponds to that of the AMB substrate 214 of Figure 11. However, due to the absence of the lower brazing layer 217, structuring of the lower aluminum 223 by etching or other removal process stopped by the additional metal layer results in a complete separation between adjoining parts 205a and 205b of the lower aluminum layer 223 during manufacturing. To avoid unwanted spikes in the electrical field strength as detailed above, an exposed part of the lower surface of the ceramic substrate 222 at a bottom of a trench 224 forming the second groove 211 is coated with a thin electrically conductive layer 225. For example, a thin copper, silver or other metal film can be applied in this area after forming the trench 224. This can be achieved using various techniques, such as thick or thin film coating, for example by chemical vapor deposition (CVD) or sputtering. In this way a direct electrical connection between the adjoining parts 205a and 205b of the second metallization layer 205 is re-established, resulting in an improved electrical field distribution as detailed below with respect to Figures 13 and 14.

Figures 13 and 14 show electrical simulations for the electrical field strength in a substrate 200 having a groove 211 in a second metallization layer 205, as explained above with regard to Figure 12. Unlike to the situation depicted in Figures 9 and 10, an exposed area at the bottom of the groove 211 of the second metallization layer 205 was coated with a thin electrically conductive layer 225 to avoid high electric field strengths and partial discharge in the second groove 211. Similar to Figures 9 and 10, in Figure 13, the upper metallization layer 202 is uninterrupted and connected to a high electrical potential and, in Figure 14, is interrupted in the area of the second groove 211 by means of a first groove 203 and connected to a high electrical potential (left) and a low electrical potential (right), respectively.

As can be seen in Figures 13 and 14, due to the electrical connection through the electrically conductive layer 225in the area of the second groove 211, no locally strongly enhanced electrical fields occur near the corners 212a and 212b. Instead, there is only a homogeneous electrical field within the insulating carrier sheet 201. Accordingly, the corners 212a and 212b are not subjected to high electrical voltage drops. In fact, the electrical field strength in the second groove 211 is relatively low and constant in Figure 13, resulting in an improved life expectancy of the manufactured substrate 200 and any encompassing power module. As for Figure 14, locally strongly enhanced electrical field strengths only occur at the edges 213a of the groove in the first metallization layer 202 required for electrical isolation between metal patterns of different electrical potential.

Figure 15 shows a further embodiment according to the present disclosure. Contrary to Figure 12, the embodiment shown in Figure 15 shows a resin sheet 228 serving as a substrate 200. In the described embodiment, different parts 202a and 202b of a first metallization layer 202 are directly deposited on an upper surface of the substrate 200, for example by any suitable additive manufacturing method.. Similarly, different parts 205a and 205b of a second metallization layer 202 are directly deposited on a lower surface of the substrate 200.

The overall structure of the substrate 200 corresponds to that shown in Figure 12. However, instead of coating an exposed part of the lower surface of the resin sheet 228, a bottom part of a trench 224 forming the second groove 211 is filled with an electrically conductive material 229. For example, the trench 224 can be filled partially or completely with a conductive adhesive or other conductive elastic material. In this way a direct electrical connection between the adjoining parts 205a and 205b of the second metallization layer 205 is re-established, resulting in the same field distribution as shown in Figures 13 and 14.

Figure 16 shows a further embodiment according to the present disclosure. It shows a direct bonded copper (DBC) substrate 226 wherein an upper copper layer 218 and a lower copper layer 219 are directly bonded to a ceramic substrate 222.

Similar to the embodiments shown in Figures 11, 12 and 15, a second groove 211 provided in a lower metallization layer 205 does not extend all the way to a ceramic substrate 222. In the described example, the second groove 211 in the lower copper layer 219 was formed by etching, and an etching method, an etching time, an etching agent and/or an etchant concentration was selected such that a resulting trench 224 does not extend all the way to the ceramic substrate 222. This can be achieved, for example, by etching the trench 224 and respective peripheral areas 227 of the DBC substrate 226 using different processes or etch masks. Alternative, other structuring methods, such as selective laser cutting may be used to remove only part of metal material of the second metallization layer 205. As above, the resulting structure will result in an improved electrical field distribution as shown in Figures 13 and 14, respectively.

While the above examples describe a coating of a trench 224 of a DBA substrate 220 using a thin electrically conductive layer 225, and the filling of a trench 224 of the substrate 200 and partial etching of a DBC substrate respectively, this is not intended to be limiting. In particular, it is also possible to provide a thin electrically conductive layer at the bottom of trench 224 of the substrate 200 shown in Figure 15, and to partially or complete fill trenches 224 of a DBA substrate 220 or DBC substrate 226, etc.

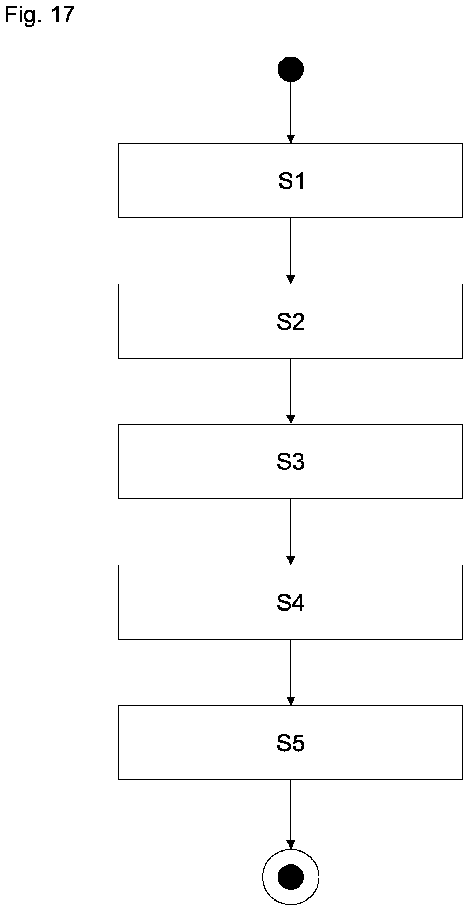

Figure 17 shows, in a schematic way, a method for manufacturing a power module 210 using steps S1 to S5. Attention is drawn to the fact that steps S1 to S5 may be performed in a different order and/or in parallel. For example, the back side of the substrate 200 may be structured before the front side is structured. Alternatively, structuring of the front and back side may be performed in parallel, for example in a single etching step.

In step S1, a substrate 200 comprising at least one insulating layer, a first metallization layer 202 and a second metallization 205 layer is provided. The first and second metallization layers 202 and 205 are arranged on opposite sides of the insulating layer. For example, as described above, a DBC substrate 226, a DBA substrate 220 or an AMB substrate 214 may be provided.

In step S2, the first metallization layer 202 is structured to form a plurality of first grooves 203 electrically separating the first metallization layer 202 into a plurality of individual parts. For example, in the case of a DBC substrate 226 or a DBA substrate 220, it is sufficient to only separate the first metallization layer 203, for example by etching. In the case of an AMB substrate 214, an upper brazing layer 216 also needs to be separated, for example by etching using a prolonged etching time or etchant concentration or by performing a separate etching step with an etching agent that is suitable to remove the chemically harder to etch brazing layer 216.

In step S3, the second metallization layer 205 is structured to form at least one second groove 211 in an attachment area 206 of the second metallization layer 205, which at least partially extends from an outer surface of the second metallization layer 205 towards the insulating layer. For example, as explained above, a trench 224 may be etched such that it either only extends to an etch stop, for example a lower brazing layer 217, or that it extends all the way to the insulating layer, such as a ceramic substrate 222. In case the initial structuring step separates the second metallization layer 205 completely, at least in some embodiments the trench 224 may be partially filled with a conductive material 225 to re-establish an electrical connection between corresponding edges of the trench 224.

In step S4, at least one semiconductor die 204 is mounted in a mounting area of the first metallization layer 202. This may be achieved, for example, by soldering, sintering, diffusion soldering, or gluing of metal contact areas of the one or more semiconductor dies 204 with corresponding parts of the first metallization layer 202. Soldering or sintering results in a heating and/or a mechanical load on the substrate 200.

In step S5, at least the attachment area 206 of the second metallization layer 205 is attached to a flat surface of an appropriate carrier structure. Again, this may be performed by soldering or sintering or any other appropriate method such as bonding with a conductive adhesive. For example, a flat surface of a base plate 208, an electrically conductive carrier plate and/or a cooler may be used as carrier structure for the power module 210. Again, the soldering or sintering will results in a heating and/or a mechanical load on the substrate 200.

The embodiments shown in Figures 1 to 17 as stated represent exemplary embodiments of improved substrates and power modules and method for their manufacturing. Therefore, they do not constitute a complete list of all embodiments according to the improved devices and methods. Actual devices and methods may vary from the embodiments shown in terms of arrangements, devices, method steps and materials, for example.

### Reference Signs

- 100: substrate
- 101: carrier sheet
- 102: first metallization layer
- 102a-c: parts (of first metallization layer)
- 103, 103a-b: (first) groove
- 104a-d: semiconductor die
- 105: second metallization layer
- 106: attachment area
- 107: central region (of attachment area)
- 108: base plate
- 109: solder
- 110: peripheral region (of attachment area)
- 111: gap
- 200: substrate
- 201: carrier sheet
- 202: first metallization layer
- 202a-c: parts (of first metallization layer)
- 203, 203a-b: (first) groove
- 204, 204a-d: semiconductor die
- 205: second metallization layer
- 205a, 205b: parts (of second metallization layer)
- 206: attachment area
- 207: mounting area
- 208: base plate
- 209: solder
- 210: power module
- 211, 211a-c: (second) groove
- 212a, 212b: corner (of second groove)
- 213a, 213b: corner (of first groove)
- 214: AMB substrate
- 215: (middle) ceramic layer
- 216: (upper) brazing layer
- 217: (lower) brazing layer
- 218: (upper) copper layer
- 219: (lower) copper layer
- 220: DBA substrate
- 221: (upper) aluminum layer
- 222: ceramic substrate
- 223: (lower) aluminum layer
- 224: trench
- 225: electrically conductive layer
- 226: DBC substrate
- 227: peripheral area
- 228: resin sheet
- 229: electrically conductive material

- S1 to S5: method steps

## Claims

1. A substrate (200) for a power module (210), comprising:
- a carrier sheet (201) extending in a plane and comprising at least one insulating layer;
- a first metallization layer (202) formed on a first surface of the carrier sheet (201), the first metallization layer (202) comprising a mounting area (207) for mounting at least one semiconductor die (204) of a power module (210); and
- a second metallization layer (205) formed on a second surface of the carrier sheet (201), the second surface being opposite to the first surface, the second metallization layer (205) comprising an attachment area (206) for attaching the substrate (200) to a flat surface;
wherein
- the projections of the mounting area (207) and the attachment area (206) into the plane of the carrier sheet (201) at least partially overlap;
- the mounting area (207) is structured using at least one first groove (203) extending from an outer surface of the first metallization layer (202) to the at least one insulating layer to electrically separate individual parts (202a, 202b, 202c) of the first metallization layer (202); and
- the attachment area (206) is structured using at least one second groove (211) extending from an outer surface of the second metallization layer (205) at least partly to the at least one insulating layer.

2. The substrate (200) of claim 1, wherein a conductive material (229) arranged at a bottom of the at least one second groove (211) interconnects edges of respective parts of the second metallization layer (205) adjoining the at least one second groove (211).

3. The substrate (200) of claim 2, wherein
- the carrier sheet (201) further comprises at least one first conductive layer arranged between the at least one insulating layer and the second metallization layer (205);
- the at least one second groove (211) extends from the outer surface of the second metallization layer (205) to a surface of the at least one first conductive layer; and
- the at least one first conductive layer interconnects the edges of the respective parts of the second metallization layer (205) adjoining the at least one second groove (211) .

4. The substrate (200) of claim 3, wherein the substrate (200) is an active metal brazing substrate (214), and the at least one conductive layer is a brazing layer (217) formed on a surface of the at least one insulating layer.

5. The substrate (200) of claim 2, wherein:
- the at least one second groove (211) comprises a trench (224) extending from the outer surface of the second metallization layer (205) to the at least one insulating layer; and
- at least one of an electrically conductive layer (225) and an elastic electrically conductive material (229) is arranged at least at a bottom part of the trench (224), such that the edges of the respective parts of the second metallization layer (205) adjoining the at least one second groove (211) are interconnected.

6. The substrate (200) of claim 5, wherein at least one of
- the substrate (200) is one of a directly bonded copper substrate (226) or a directly bonded aluminum substrate (220); and
- the second metallization layer (205) is directly bonded to a surface of the at least one insulating layer of the carrier sheet (201).

7. The substrate (200) of claim 2, wherein the at least one second groove (211) comprises a trench (224) extending only partially from the outer surface of the second metallization layer (205) towards the insulating layer, such that remaining material of the second metallization layer (205) below the trench (224) interconnects the edges of the respective parts of the second metallization layer (205) adjoining the at least one second groove (211).

8. The substrate (200) of claim 1, wherein the at least one second groove (211) extends from the outer surface of the second metallization layer (205) to the insulating layer.

9. A power module (210), comprising
- the substrate (200) of any one of claims 1 to 8; and
- at least one semiconductor die (204) mounted in the mounting area (207) of the first metallization layer (202).

10. The power module (210) of claim 9, further comprising a carrier structure, wherein the attachment area (206) is attached to a flat surface of the carrier structure, the carrier structure comprising at least one of:
- an electrically conductive carrier plate in electrical and/or thermal contact with the second metallization layer (210) ;
- a base plate (208) in thermal contact with the second metallization layer (210); or
- a cooler in thermal contact with the second metallization layer (210).

11. The power module (210) of claim 9 or 10, wherein at least one of:
- patterns of the at least one first groove (203) and the at least one second groove (211) are balanced such that the attachment area (206) of the second metallization layer (205) of the substrate (200) carrying the at least one semiconductor die (204) remains essentially flat during heat treatment of the substrate (200);
- an amount of material of the first metallization layer (202) corresponds to an amount of material of the second metallization layer (205);
- the at least one first groove (203) and the at least one second groove (211) cover a corresponding surface area of the carrier sheet (201);
- the at least one first groove (203) and the at least one second groove (211) have a corresponding volume;
- a thickness of the first metallization layer (202) corresponds to a thickness of the second metallization layer (205) and the at least one first groove (203) and the at least one second groove (211) are congruent; or
- a thickness of the first metallization layer (202) differs from a thickness of the second metallization layer (205) and at least parts of the at least one first groove (203) and the at least one second groove (211) are non-congruent.

12. A method for manufacturing a power module (210), comprising:
- providing a substrate (200) comprising at least one insulating layer, a first metallization layer (202) and a second metallization layer (205), the first and second metallization layers (202, 205) being arranged on opposite sides of the insulating layer;
- structuring the first metallization layer (202) to form at least one first groove (203) electrically separating the first metallization layer (202) into a plurality of individual parts (202a, 202b, 202c);
- structuring the second metallization layer (205) to form at least one second groove (211) in an attachment area (206) of the second metallization layer (205), wherein the at least one second groove (211) extends at least partially from an outer surface of the second metallization layer (205) towards the insulating layer;
- mounting a least one semiconductor die (204) in a mounting area (207) of the first metallization layer (202); and
- attaching at least the attachment area (206) of the second metallization layer (205) to a flat surface.

13. The method of claim 12, wherein
- in the step of providing a substrate (200), a multi-layer substrate (200) comprises at least one further metal layer arranged between the insulating layer and the second metallization layer (205) is provided; and
- in the step of structuring the second metallization layer (205), the at least one further metal layer serves as at least one of an etch-stop in an etching process or a processing-stop in a structuring process.

14. The method of claim 12, further comprising
- coating or filling at least a bottom part of the at least one second groove (211) with a conductive material (225) to form an electrical interconnection between respective parts of the second metallization layer (205) adjoining the at least one second groove (211).

15. The method of claim 12, wherein
- in the step of structuring the second metallization layer (205), the second metallization layer (205) is etched, and
- an etching method, an etching time, an etching agent and/or an etchant concentration is selected such that the at least one second groove (211) does not extend all the way to the insulating layer.
